# EUROPÄISCHE PATENTSCHRIFT

(11) **EP 2 214 151 B1**
(45) Veröffentlichungstag und Bekanntmachung des Hinweises auf die Patenterteilung: **27.07.2016**
(21) Anmeldenummer: 10000858.0
(22) Anmeldetag: 28.01.2010
(51) Int. Cl.: G09F 9/33, G09F 13/22, H01L 51/52, H01L 27/32, H01L 51/00

(54) **Licht abstrahlende plattenförmige Anordnung**
Light-emitting board-shaped assembly
Agencement en forme de plaque rayonnant de la lumière

(30) Priorität: 29.01.2009 DE 102009006655
(43) Veröffentlichungstag der Anmeldung: 04.08.2010
(73) Patentinhaber: Emde, Thomas, 60389 Frankfurt (DE)
(72) Erfinder: Emde, Thomas, 60389 Frankfurt am Main (DE)
(74) Vertreter: Fritz & Brandenburg Patentanwälte

(56) Entgegenhaltungen:
- EP-A1- 1 600 688
- EP-A2- 1 708 294
- EP-A2- 1 923 931
- WO-A1-97/38445
- WO-A2-2004/013920
- DE-A1-102006 060 781
- JP-A- 2009 223 023
- US-A1- 2008 266 490
- BHARATHAN JAYESH ET AL: "Polymer electroluminescent devices processed by inkjet printing: I. Polymer light-emitting logo" APPLIED PHYSICS LETTERS, AIP, AMERICAN INSTITUTE OF PHYSICS, MELVILLE, NY, US LNKD- DOI:10.1063/1.121090, Bd. 72, Nr. 21, 25. Mai 1998 (1998-05-25), Seiten 2660-2662, XP012020277 ISSN: 0003-6951

## Beschreibung

Die vorliegende Erfindung betrifft eine plattenförmige flächig Licht abstrahlende Anordnung umfassend wenigstens eine als OLED ausgebildete Schicht/Schichtanordnung oder elektrolumineszierende Schicht/Schichtanordnung auf einem als Träger dienenden Substrat, wobei die wenigstens eine als OLED ausgebildete Schicht/Schichtanordnung oder elektrolumineszierende Schicht/Schichtanordnung auf dem als Träger dienenden Substrat in einem Beschichtungsraster ausgebildet ist.

OLEDs (organische Licht emittierende Dioden) haben sowohl für die Bildwiedergabe in Form von Displays als auch in der Beleuchtungstechnik als flächige Leuchtmittel in letzter Zeit eine erhebliche Bedeutung erlangt. Typischerweise umfasst eine OLED eine Anordnung von Schichten auf einem Substrat, welches beispielsweise Glas oder Kunststoff ist und bevorzugt transparent ist, was davon abhängig ist, nach welcher Seite hin bei der plattenförmigen Anordnung die Lichtabgabe erfolgt. Auf dieses Substrat aufgebracht wird eine erste Elektrodenschicht, meist eine Anode, daran schließen sich im Schichtaufbau beispielsweise an eine Löcher injizierende Schicht, eine Löcher transportierende Schicht, die eigentliche Licht emittierende Schicht, eine Elektronen transportierende Schicht, eine Elektronen injizierende Schicht und eine zweite Elektrodenschicht, meist die Kathode. Ein typischer Schichtaufbau ist in der WO 2008/094399 A1 beschrieben. Es ist bekannt, für OLEDs transparente Elektrodenschichten zu verwenden. Die Schichtdicken sind bei den OLEDs der neuesten Generation sehr gering, beispielsweise beträgt die kombinierte Schichtdicke der organischen Schichten weniger als 500 nm.

Bei OLEDs welche nur Licht einer Farbe abgeben (so genannte monochrome OLEDs) erfolgt nach dem Stand der Technik die Aufbringung einer kontinuierlichen Licht emittierenden Schicht auf das Substrat. Dabei kann auch zur Erzielung der Abgabe von weißem Licht eine Mehrzahl von Licht emittierenden Schichten übereinander angeordnet werden, die Licht nur in einzelnen Spektralbereichen (farbiges Licht) emittieren, wie dies beispielsweise in der WO 2008/094399 A1 beschrieben ist.

Bislang ist jedoch herstellungsbedingt die Größe der OLEDs beschränkt. Im Bereich der Bildschirme (OLED-Displays) liegt derzeit die maximale Größe der in Serie produzierten OLEDs bei einer Bildschirmdiagonale von nur 11 Zoll, was einem Diagonalmaß von 27,94 cm entspricht. In der Regel werden OLED-Displays mit rechteckigem oder quadratischem Umriss in dieser Größe hergestellt. Auch die maximale Größe der heute in Serie angebotenen weißen OLEDs, die zu Beleuchtungszwecken eingesetzt werden, liegt in dieser Größenordnung, so dass es sich um leuchtende rechteckige oder quadratische Flächen mit Abmessungen in den Kantenlängen von weniger als 20 cm handelt. Insbesondere bei Passivmatrix-Displays, bei denen Anode und Kathode aus engen, um 90 ° versetzten Leiterbahnen bestehen, ist aufgrund von Verlusten in den elektrischen Leitungen die Größe des Displays begrenzt.

Bei den für die Beleuchtung eingesetzten OLEDs und erst recht im Bereich der OLED-Displays wird nach dem Stand der Technik davon ausgegangen, dass es wichtig ist, eine möglichst homogene durchgehende Beschichtung mit der oder den organisches Licht emittierenden Schichten zu erreichen. Bei den OLED-Displays wird eine hohe Pixeldichte angestrebt, schon um eine hohe Bildauflösung zu erreichen, das heißt die einzelnen ansteuerbaren Bildpunkte müssen in zwei Dimensionen dicht beieinander liegen. Bei den zur Beleuchtung eingesetzten OLEDs möchte man eine homogene durchgehende gleichmäßig leuchtende Fläche ohne Unterbrechungen schaffen. Bei einem kommerziell erhältlichen OLED-Display mit einer Diagonale von 11 Zoll wird zum Beispiel eine Pixeldichte von 960 x 540 Bildpunkten angegeben. Bei einem Bildschirmformat von 16 : 9 ergibt sich mit einer Diagonalen von 11 Zoll (= 27,94 cm) ein Format von etwa 9,58 x 5,39 Zoll, das heißt man erhält eine Pixeldichte von etwa 100 Pixel pro Zoll (inch). Auf einem Zoll² (inch²) befinden sich damit 10.000 Bildpunkte, was bedeutet, dass sich auf einem mm² in etwa 16 Bildpunkte befinden. Das menschliche Auge kann daher in einem solchen Fall den einzelnen Bildpunkt nicht mehr als solchen wahrnehmen, sondern nimmt eine einheitliche leuchtende Fläche wahr.

Momentan arbeitet man an der Entwicklung von OLEDs mit größerer Fläche. Da es jedoch erforderlich ist, meist mehrere sehr dünne Schichten mit sehr geringen Schichtdicken im sub-µ-Bereich homogen auf eine größere Fläche aufzubringen, ergeben sich hier verschiedene technische Schwierigkeiten. Ein Problem ist beispielsweise auch die ungleichmäßige Stromdichte in einer rechteckigen mit OLED beschichteten Fläche. Flächen im Bereich der Nähe der Flächenecken erhalten mehr Strom als Flächenbereiche im Inneren der Fläche. Da die Herstellung von OLEDs mit größeren Flächen bislang technisch sehr aufwändig ist, ergeben sich hohe Herstellkosten pro Flächeneinheit, weshalb diese OLEDs verglichen mit herkömmlichen Leuchtmitteln oder Bildschirmen am Markt nicht konkurrenzfähig sind.

Ein weiteres Problem bei der Verwendung von OLEDs als Leuchtmittel ergibt sich, dass bei den aus Gründen einer höheren Lichtausbeute angestrebten höheren Leuchtdichten eine größere beispielsweise hell weiß leuchtende Fläche vom Betrachter als unangenehm empfunden wird, was bedeutet, unter physiologischen Aspekten ist eine solche Beleuchtung ungünstig.

In dem Artikel "Polymer electroluminescent devices processed by inkjet printing: I.Polymer light-emitting logo" von Bharathan Jayesh et al., erschienen in Applied Physics letters, AIP, American Institute of Physics, Melville, NY, USA LNKD-DOI:10.1063/1.121090, Bd. 72, Nr. 21, 25. Mai 1998 (1998-05-25), Seiten 2660-2662, XP012020277 ISSN: 0003-6951 ist eine OLED-Anzeige zur monochromen Wiedergabe eines Graustufenbildes offenbart. Hier werden Bildpunkte eines Licht abgebenden organischen Polymeren in einem Punktraster mittels Tintenstrahldruck auf ein mit ITO beschichtetes Glassubstrat aufgebracht. Die Graustufe des Bildes kann variiert werden durch Änderung der Punktgröße oder der Dichte der Bildpunkte. Die als Anode dienende ITO-Schicht ist transparent. Als Kathode wird jedoch eine durchgehende Schicht aus Ca verwendet, die sich auch auf Bereiche erstreckt, in denen sich keine Bildpunkte befinden. Durch diese Kathodenschicht wird eine Transparenz in nicht mit Bildpunkten beschichteten Bereichen verhindert.

In der EP 1 600 688 A1 wird eine Beleuchtungsfläche mit elektrischen lichtemittierenden Verbrauchern beschrieben, wobei eine transparente Folie als Trägerfläche dient. Auf diese Trägerfläche ist eine Drahtmatrix aus dünnen unisolierten Drähten aufgeklebt. Als Leuchtmittel können Leuchtdioden an den Kreuzungspunkten zwischen den elektrischen Leitern dienen, die beispielsweise durch Löten elektrisch verbunden werden. Gemäß dem Ausführungsbeispiel sind die LEDs in einem sehr weiten Raster angeordnet, bei dem die jeweiligen Abstände der LEDs untereinander ein Mehrfaches des Durchmessers der LEDs betragen. In dieser Schrift wird auch die Möglichkeit der Verwendung von organischen Leuchtdioden (OLEDs) erwähnt, wozu jedoch keine konkreten Lösungsbeispiele beschrieben werden.

Die Aufgabe der vorliegenden Erfindung besteht darin, eine alternative plattenförmige Anordnung der eingangs genannten Gattung zur Verfügung zu stellen, die die Schaffung eines für den Menschen angenehmer wirkenden Lichts zulässt und die die Herstellung auch größerer leuchtender Flächen oder Displays mit vertretbarem technischen Aufwand ermöglicht, wobei trotz Aufbringung des OLED-Beschichtungsrasters eine Durchsicht im Bereich von Teilflächen der plattenförmigen Anordnung, die aus transparentem Trägermaterial bestehen, möglich ist.

Die Lösung dieser Aufgabe liefert eine plattenförmige Anordnung der eingangs genannten Gattung mit den kennzeichnenden Merkmalen des Anspruchs 1 bzw. des Anspruchs 2.

Die vorliegende Erfindung denkt demnach in eine andere Richtung als der Stand der Technik, der bislang den Zweck verfolgte, große leuchtende Flächen oder großflächige Displays zu schaffen, die homogen mit der OLED-Schicht versehen sind, wobei diese eine hohe Bildpunktdichte von beispielsweise in der Größenordnung 1600 Bildpunkte pro cm² aufweist. Dagegen schlägt die vorliegende Erfindung vor, quasi ein Beschichtungsraster von beabstandeten mit OLED beschichteten Bereichen zu schaffen, zwischen denen sich unbeschichtete Bereiche befinden. Die Beschichtung ist also erfindungsgemäß diskontinuierlich und nicht flächendeckend. Dies hat eine Reihe von Vorteilen.

Zwar sind bereits aus dem Stand der Technik teilweise transparente Schichten für OLEDs bekannt, beispielsweise können die die Elektroden bildenden Schichten aus transparenten Materialien bestehen. Meist sind jedoch nicht alle Schichten des OLED-Schichtaufbaus transparent. Selbst wenn man aber eine vollständig transparente OLED-Beschichtung auf ein transparentes Substrat aufbringen würde, ist eine Durchsicht nach dem Stand der Technik natürlich nur im ausgeschalteten Zustand möglich. Hier schafft die Erfindung die Möglichkeit, die mit OLED beschichteten Bereiche in so geringer Flächendichte auf ein transparentes Substrat aufzubringen, dass auch bei eingeschaltetem OLED eine Durchsicht durch die OLED-Beschichtung und die plattenförmige Anordnung insgesamt möglich ist.

Vorzugsweise beträgt das Verhältnis der beschichteten Bereiche der Fläche zu den neutralen unbeschichteten Bereichen der Fläche weniger als 0,25, was bedeutet, dass bevorzugt weniger als 20 % der insgesamt verfügbaren Fläche beschichtet ist.

Da nur die beschichteten Bereiche Licht abstrahlen ist die Leuchtdichte pro Flächeneinheit naturgemäß geringer als bei einer herkömmlichen homogen und dicht beschichteten OLED, wodurch das abgestrahlte Licht keine leuchtende, geschlossene Fläche bildet und das Licht wirkt natürlicher und organischer, weniger direkt und wird damit vom Betrachter als angenehmer empfunden. Die Abstrahlung entspricht in der Anmutung eher der in der Natur vorkommenden diffusen Lichtabstrahlung. Die insbesondere rasterartig aufgebrachte Beschichtung verhindert eine zum Betrachter hin geschlossene Fläche und unterstützt einen optischen natürlichen Raumeindruck.

Bei der erfindungsgemäßen plattenförmigen Anordnung können die OLED-Schicht oder die OLED-Schichten beispielsweise zunächst auf ein erstes Trägermaterial aufgebracht werden, z. B. auf Folien, Gläser, Metalle, Keramik, Kunststoffe oder andere geeignete Materialien. Diese ersten Träger können anschließend gegebenenfalls auf einen weiteren transparenten Träger aufgebracht werden, wie z. B. Fensterglas, eine Glas- Trennwand, Glasfassade, Kunststoffglas (beispielsweise Acrylglas) oder dergleichen.

Dieses obengenannte erste Trägermaterial kann alternativ anschließend beispielsweise auch auf einen nichttransparenten Träger aufgebracht werden wie z. B. eine Metallfassade, ein Möbel oder einen Teil davon, eine Fliese, ein physikalisches Trägermaterial für Wandverkleidungen.

Diese genannten ersten Trägermaterialien können starr oder flexibel sein. Diese ersten Trägermaterialien können transparent, lichtdurchlässig, opak oder lichtundurchlässig sein.

Das als Trägermaterial dienende Substrat, auf welches die OLED-Beschichtung aufgebracht wird, kann gemäß einer bevorzugten Weiterbildung der Erfindung beispielsweise eine Glasscheibe sein. Dieses Substrat kann von einer oder von beiden Seiten mit einer oder mehreren Schichten rasterförmig beschichtet werden.

Weiterhin können beispielsweise auch mehrere einseitig oder beidseitig beschichtete Träger dieser Art hintereinander, übereinander, untereinander oder nebeneinander angeordnet werden.

Die erfindungsgemäßen Beschichtungsraster können zum Beispiel aus Punkt-, Strich- oder anderen Rasterdesigns hergestellt sein.

Wenn man mehrere Substrate übereinander oder hintereinander verwendet können die Substrate so angeordnet sein, dass die Beschichtungsraster passgenau übereinander bzw. hintereinander platziert sind, sie können jedoch auch versetzt zueinander platziert sein.

Die Rasterbeschichtung kann im Aus - Zustand der OLEDs transparent, opak oder farbig sein.

Die Rasterbeschichtung kann bei An - Zustand weißes Licht abgeben, oder weißes Licht in verschiedenen Farbtemperaturen.

Wenn ein Substrat beidseitig beschichtet ist, kann die Beschichtung beispielsweise einer transparenten Trägerplatte auf deren einer Seite eine andere Lichtqualität abgeben als die Beschichtung derselben Trägerplatte auf deren anderer Seite (beispielsweise Vorder- bzw. Rückseite oder Ober- und Unterseite.)

Entsprechend können bei Verwendung mehrerer Trägerplatten die unterschiedlichen Vorder- und Rückseiten mehrerer hinter, über oder nebeneinander angeordneter Platten unterschiedliche Lichtqualitäten abgeben.

Die Lichtabgabe der einzelnen Beschichtungen auf den unterschiedlichen Vorder- und Rückseiten der Trägerplatten kann beispielsweise elektronisch in ihrer Intensität und Farbigkeit gesteuert werden. Es können auch einzelne Flächenbereiche eines Beschichtungsrasters oder einzelne Gruppen solcher Beschichtungsbereiche voneinander unabhängig elektronisch angesteuert werden.

Im Rahmen der vorliegenden Erfindung kommen für die Beschichtung neben OLEDs prinzipiell alle sonstigen elektrolumineszierenden, das heißt "durch Elektrizität" zum Leuchten aktivierbaren Substanzen in Frage.

Für die Aufbringung der Schicht bzw. der Schichten der Schichtanordnung kommen im Rahmen der vorliegenden Erfindung die unterschiedlichsten Verfahren in Betracht. Beispielsweise können die Schichten aufgedruckt, aufgerollt, lackiert, gesprüht, bedampft, besiebdruckt, über Inkjet- oder Tintenstrahldrucker oder auf andere Art aufgebracht werden.

Die in einem Beschichtungsraster auf ein Substrat aufgebrachten OLED-Flächen können an einem von dem Substrat unabhängigen Produkt unterschiedlichster Art in den verschiedensten Anordnungen angebracht werden, beispielsweise vor, hinter, auf, unter, in einem Produkt oder Gegenstand oder zwischen Teilen eines Gegenstands nahezu beliebiger Art. Beispielsweise können Glasplatten mit gerasterten OLED-Flächen als zusätzliche Scheiben von innen oder außen an einer vorhandenen Glasfassade angebracht werden.

Wenn es sich bei der OLED-Beschichtung oder elektrolumineszierenden Beschichtung um eine nicht transparente Beschichtung auf einem transparenten oder weitgehend transparenten Träger wie beispielsweise einer Glasplatte als Teil eines Gebäudes handelt, kann diese Beschichtung als passiver Sonnenschutz genutzt werden, da durch die Beschichtungsbereiche der Anteil des einfallenden Sonnenlichts verringert wird. Die erfindungsgemäße plattenförmige Anordnung verfügt damit über die Eigenschaften einer Kombination von Lichtfläche und Sonnenschutz. Bei dieser Variante der Erfindung kann man auch Beschichtungsbereiche vorsehen, die rasterförmig sich auf der beschichteten Substratfläche erstrecken, wobei die OLED-Bereiche am gleichen Ort liegen können wie die Bereiche, die den passiven Sonnenschutz liefern, sie können jedoch auch versetzt zu den Bereichen für den passiven Sonnenschutz liegen. Definierte Beschichtungsbereiche können somit mehrere Funktionen übernehmen (OLED-Beschichtung gleichzeitig als passiver Sonnenschutz) oder aber die Beschichtungsbereiche mit verschiedenen Funktionen sind voneinander getrennt.

Die Bereiche für den passiven Sonnenschutz und die OLED-Flächen können dabei auf einer gleichen Oberfläche eines Substrats aufgebracht sein, sie können aber auch beispielsweise voneinander getrennt auf Vorder- und Rückseite eines plattenförmigen Substrats angebracht sein.

Ein weiterer Vorteil ergibt sich bei einer Ausführungsvariante der vorliegenden Erfindung, wenn man zum Beispiel die genannte Beschichtung gleichzeitig auf Oberflächen eines Gegenstands vorsieht, welche aus verschiedenen Materialien bestehen, beispielsweise auf metallischen Flächen und Glasflächen eines Gebäudes. Die gleichartige Rasterung der leuchtenden OLED-Flächen verbindet dann optisch bei Dunkelheit bei Tage unterschiedlich wirkende Oberflächen, beispielsweise Aluminiumfassadenteile und Glasfassadenteile. Hierdurch ist mittels einer leuchtenden Beschichtung eine völlig neue Designmöglichkeit für die Lichtgestaltung bei Dunkelheit auf unterschiedlichen Materialien gegeben. Die Lichtgestaltung durch die OLED-Rasterung vereint bei Dunkelheit die unterschiedlichen Materialien.

Erfindungsgemäß beschichtete plattenförmige Träger aus Glas können beispielsweise zu Isolierglas, Normalglas, oder anderen Gläsern wie ESG, TVG, VSG verarbeitet werden.

Die nicht beschichteten Bereiche des Substrats, also die Zwischenräume der Rasterbeschichtung können transparent oder nichttransparent sein. Je nachdem wie die Kontaktierung der Beschichtungsbereiche vorgesehen ist, können diese Zwischenräume stromführend sein oder auch nicht stromführend, wenn beispielsweise die Kontaktierung über Elektrodenschichten erfolgt, die unter oder über den Licht abgebenden Beschichtungsbereichen liegen.

Die Beschichtungsbereiche des Beschichtungsrasters können gemäß einer bevorzugten Weiterbildung der Erfindung beispielsweise von einer Seite z. B. mit einer Substanz abgedeckt sein, die in schwarzer oder grauer Farbe erscheint oder spiegelnd wirkt, um die Durchsicht bei An und / oder Auszustand der OLEDs zu verbessern. Eine solche Beschichtung ist auch vorteilhaft, wenn die OLED-Beschichtungsbereiche z. B. transparent sind, um die Durchsicht bei an und / oder Auszustand zu verbessern. Diese z. B. spiegelnde oder graue oder schwarze Abdeckung kann dann beispielsweise auch als passiver Sonnenschutz dienen.

Man kann auch beispielsweise ein, zwei oder mehrere transparente plattenförmige Substrate ein- oder zweiseitig beschichten mit zum Teil transparenten und zum Teil nicht transparenten Licht emittierenden Substanzen. Die nicht transparenten Bereiche dienen dann als passiver Sonnenschutz, es wird jedoch die größtmögliche Lichtausbeute erzielt.

Eine Halterung der beispielsweise plattenförmigen Träger aus Glas in den Kantenbereichen ist bei der erfindungsgemäßen Lösung anders als bei der aus dem Stand der Technik bekannten Verwendung von LEDs zur Kanteneinspeisung von Licht nicht notwendig.

Ein weiterer Vorteil gegenüber aus dem Stand der Technik bekannten Lösungen besteht gemäß einer Variante der Erfindung darin, dass die Oberfläche von erfindungsgemäß beschichteten Glasplatten besser zu reinigen ist, da sich an der Oberfläche keine Erhebungen dort ergeben, wo beschichtete Bereiche vorliegen, denn die OLED-Bereiche werden in der Regel zum Schutz der OLEDs gegen Sauerstoff und Feuchtigkeit verkapselt, die Beschichtungsbereiche sind also bei einer Glasplattenanordnung innenliegend, sie liegen unter einer Schutzschicht, die glatt ausgeführt werden kann.

Die beschichteten Bereiche des Beschichtungsrasters können monochrom leuchten oder auch in einem RGB-Modus (rote, grüne und blaue Beschichtungsbereiche), wobei gleiche oder verschiedenfarbige Beschichtungs-Punkte übereinander oder nebeneinander oder versetzt übereinander liegen können.

Es kann nur eine Seite eines Substrats beschichtet sein oder beide Seiten eines insbesondere transparenten Trägers, wobei diese entweder in gleicher Weise oder in einem unterschiedlichen Modus beschichtet sein können.

Die beschichteten Flächen können flach oder gekrümmt oder in geeigneter Weise entsprechend dem Anwendungszweck verformt sein. Sie können vor einer Verformung oder danach beschichtet werden.

Ein erfindungsgemäß beschichteter Träger kann gemäß einer Weiterbildung der Erfindung wenigstens eine verspiegelte Fläche aufweisen.

Bei Verwendung einer geeigneten Steuerung bieten sich im Beleuchtungsbereich oder beispielsweise bei Werbe- oder Informationsdisplays vielfältige Anwendungsmöglichkeiten zur effektvollen Nutzung erfindungsgemäß beschichteter plattenförmiger Träger. Beispielsweise können einzelne Rasterlinien eines Beschichtungsrasters separat zugeschaltet werden, um einfache Ornamente zu erzeugen, oder das Licht baut sich beispielsweise linienweise von oben nach unten auf oder umgekehrt oder von innen nach außen oder umgekehrt.

Das bei den aus dem Stand der Technik bekannten OLEDs mit homogener flächiger Beschichtung gegebene Problem der ungleichmäßigen Stromverteilung in der Fläche ( Ecken der Fläche erhalten im Verhältnis zum Flächeninneren mehr Strom) wird durch die erfindungsgemäße Lösung überwunden. Dadurch, dass man die einzelnen Beschichtungsbereiche separiert, kann man auch je nach deren Positionierung auf einem beschichteten Träger z. B. kleinere oder größere Beschichtungsbereiche im Raster vorsehen, und/oder größere oder kleinere Zwischenräume zwischen diesen. Man erhält damit zwei zusätzliche Freiheitsgrade. Eine rasterartige Beschichtung muss also im Sinne der vorliegenden Erfindung keineswegs aus immer gleich großen oder gleich beabstandeten Beschichtungsbereichen bestehen. Man kann diese Größenunterschiede oder Abweichungen in den Zwischenräumen auch nur geringfügig variieren, so dass dies bei Betrachtung einer beschichteten Fläche aus gewöhnlicher Entfernung kaum wahrgenommen wird.

Ein weiteres Problem der OLED Herstellung nach dem heutigen Stand der Technik ergibt sich aus der Anforderung des gleichmäßigen Auftragens der Schichten. Ein homogenes Herstellen der dünnen Schichten ist technisch äußerst schwierig. Die heutige Technik lässt eine größere optisch homogene Lichtfläche nicht zu. Eine gleichmäßige oder annähernd gleichmäßige Schichtstärke ist mit einer Aufrasterung der Fläche wesentlich einfacher zu erreichen. Eine Schwankung der Schichtdicke ist in einer Rasterung eher zu akzeptieren als in einer homogenen gleichmäßigen Fläche. Dieses Phänomen und die einfachere technische Umsetzung führt dazu, das mittels einer Rasterung nach dem Prinzip der vorliegenden Erfindung aus OLEDs optisch ansprechende Produkten zu vertretbaren Kosten herstellbar sind, da nicht mehr das Ziel einer annähernd idealen Homogenität verfolgt wird, sondern das Ergebnis einer Rasterauflösung genügt. Bei der erfindungsgemäßen Lösung steht auch nicht die Maximierung der Lichtausbeute im Vordergrund. Dafür lassen sich erfindungsgemäß wesentlich größere Licht abgebende mit OLED beschichtete Flächen (in nahezu beliebiger Größe) schaffen, wodurch sich völlig neue Anwendungsmöglichkeiten ergeben, wohingegen die genannten technischen Schwierigkeiten bei den bekannten Lösungen bislang eine breite Nutzung von OLEDs im Bereich der Beleuchtung oder Displays verhindern.

Ein weiterer Vorteil der erfindungsgemäßen Lösung liegt darin, dass bei der Beschichtung von Glasplatten nicht notwendigerweise teures Weißglas verwendet werden muss, um das Licht parallel zur Fläche zu leiten, wie bei den bekannten Lichtleitern aus Glas, bei denen Licht stirnseitig in eine Glasplatte eingeleitet und dann als Streulicht ausgekoppelt wird. Nach dem Stand der Technik werden für das Aufbringen lichtstreuender Beschichtungen auf Lichtleitgläsern in der Regel Siebdruckverfahren verwendet. Ein weiterer Vorteil der Erfindung liegt darin, dass die OLED-Beschichtung bei Aufdrucken nicht durch ein teures Siebdruckverfahren aufgebracht werden muss, sondern hierzu kostengünstige Verfahren wie zum Beispiel Tintenstrahldrucken zur Verfügung stehen. Diese Verfahren ermöglichen es, jedes einzelne Motiv direkt erzeugen. Beim Siebdrucken erfordert hingegen die kleinste Änderung eines Siebdruckmotives eine komplette Umstellung des notwendigen Siebes incl. Spannen, Beschichten, Belichten, Auswaschen, neuem Siebrahmen, und neues Einrichten.

Die in den Unteransprüchen genannten Merkmale betreffen bevorzugte Weiterbildungen der erfindungsgemäßen Aufgabenlösung. Weitere Vorteile der Erfindung ergeben sich aus der nachfolgenden Detailbeschreibung.

Nachfolgend wird die vorliegende Erfindung anhand von Ausführungsbeispielen unter Bezugnahme auf die beiliegenden Zeichnungen näher beschrieben.

Dabei zeigen:
Figur 1 eine schematisch vereinfachte Draufsicht auf einen Ausschnitt aus einer erfindungsgemäß beschichteten Platte gemäß einem möglichen Ausführungsbeispiel;
Figur 2 eine weitere Draufsicht auf einen Ausschnitt aus einer erfindungsgemäß beschichteten Platte gemäß einer alternativen beispielhaften Ausführungsvariante;
Figur 3 eine schematisch vereinfachte Längsschnittansicht durch einen Ausschnitt einer erfindungsgemäßen plattenförmigen Anordnung.

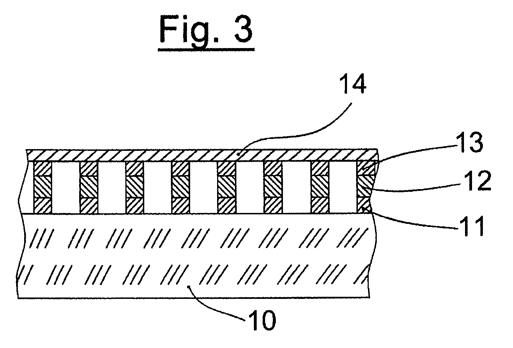

Nachfolgend wird zunächst auf die Figur 3 Bezug genommen. Die Darstellung zeigt einen Ausschnitt durch eine beispielhafte erfindungsgemäße plattenförmige Anordnung, wobei die Darstellung stark schematisch vereinfacht ist und nicht maßstabsgetreu ist, da sie nur zur Veranschaulichung der Erfindung dient. Man erkennt den als Substrat dienenden plattenförmigen Träger 10, beispielsweise eine Glasplatte. Dieser ist gemäß dem vorgegebenen Beschichtungsraster bereichsweise beschichtet mit einer Schichtanordnung, die mehrere Schichten umfasst, wobei die Darstellung hier vereinfacht und nicht alle Schichten gezeigt sind, sondern nur die wichtigsten. In der Praxis ist der Aufbau der Schichtanordnung meist komplexer und besteht aus einer größeren Anzahl von Schichten. Derartige Schichtaufbauten von OLEDs sind aber grundsätzlich aus dem Stand der Technik bekannt und werden daher hier nicht im Detail erläutert.

Die beschichteten Bereiche weisen beispielsweise eine Anodenschicht 11 auf, die sich hier auf dem Substrat befindet, an die sich dann nach oben hin eine Licht emittierende Schicht 12 anschließt, auf die dann wiederum eine Kathodenschicht 13 folgt. Da die heute bekannten OLEDs empfindlich sind gegen Sauerstoff und Feuchtigkeitseinflüsse ist die gesamte Beschichtung jeweils durch eine Abdeckschicht 14 oberseitig abgedeckt, so dass die OLEDs verkapselt sind. Die Licht emittierende Schicht 12 wurde hier nur einschichtig dargestellt. Diese besteht jedoch meistens auch aus mehreren Schichten, die nacheinander aufgebracht werden, insbesondere beispielsweise mehrere OLED-Schichten, die in verschiedenen Farben des Spektrums emittieren, so dass die Lichtfarbe des abgegebenen Lichts variiert werden kann, oder um weißes Licht aus einer Summe von farbigen Lichtquellen nach dem RGB-Modus zu erzeugen.

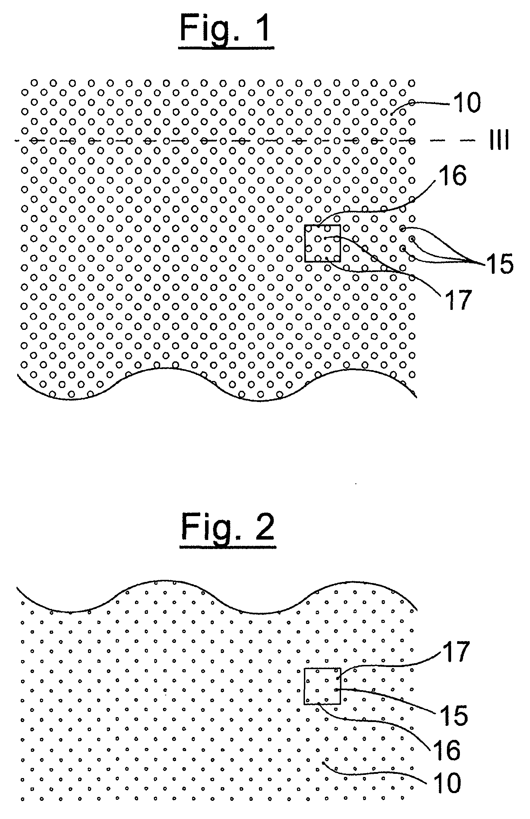

Zwei Beispiele für mögliche Beschichtungsraster zeigen die Figuren 1 und 2, auf die nachfolgend Bezug genommen wird. Figur 1 zeigt ein Ausführungsbeispiel mit einem dichteren Beschichtungsraster, wobei es sich hier um ein Punktraster aus einer Vielzahl beabstandeter Rasterpunkte 15 handelt, die auf die Oberfläche eines Substrats, zum Beispiel einen transparenten plattenförmigen Träger aufgedruckt sind. Mit 16 ist ein Ausschnitt aus dem Raster bezeichnet, beispielsweise in der Größe von einem cm². Wie man sieht, sind die Rasterpunkte 15 in Reihen aufgedruckt und haben hier in jeder Reihe jeweils einen gleichmäßigen Abstand (was natürlich nicht unbedingt erforderlich ist, da die Abstände auch unregelmäßig sein können. Die Darstellung ist nur als Beispiel zu verstehen.) Zwischen den Reihen sind wiederum Abstände, so dass sich zwischen den einzelnen Rasterpunkten 15 und zwischen den Reihen jeweils Zwischenräume 17 ergeben, die keine Licht abstrahlende Beschichtung aufweisen.

In dem Beispiel befinden sich in einem Ausschnitt 16 von 1 cm² wie man erkennt insgesamt acht Rasterpunkte 15, die jeweils einen Durchmesser von etwa 1,76 mm aufweisen. Wenn man von der vereinfachenden Annahme ausgeht, dass die Rasterpunkte im Umriss etwa kreisförmig sind, dann ergibt sich bei jeweils Abständen von ca. 5,4 mm zwischen zwei benachbarten Punkten einer Reihe und jeweils versetzter Anordnung der Rasterpunkte zweier benachbarter Reihen wie in der Darstellung und einem Reihenabstand, der etwa der Hälfte des Abstandes der Rasterpunkte innerhalb einer Reihe entspricht bei jeweils acht Rasterpunkten pro cm² ein Bedeckungsgrad der beschichteten Bereiche bezogen auf die Gesamtfläche von etwa 19,4 % und ein Verhältnis der Fläche der beschichteten Bereiche zur Fläche der unbeschichteten Bereiche von etwa 0,24.

Ein weiteres Ausführungsbeispiel mit einem weniger dichten Beschichtungsraster ist in Figur 2 dargestellt. Wie man aus dem Ausschnitt 16 erkennt, befinden sich auch dort jeweils 8 Rasterpunkte der Beschichtung auf einem Flächenausschnitt mit der Größe von 1 cm². Die Anzahl der Rasterpunkte 15 in dem Beschichtungsraster ist also die gleiche wie in dem Ausführungsbeispiel von Figur 1, jedoch sind bei Figur 2 die einzelnen etwa punktförmigen Beschichtungsbereiche im Durchmesser kleiner. Die Abstände der Rasterpunkte 15 in einer Reihe beträgt auch hier (von Mittelpunkt zu Mittelpunkt) wieder 5,4 mm. Der Durchmesser eines Rasterpunkts 15 beträgt hier beispielsweise nur 0,75 mm. Damit beträgt der Radius r eines Rasterpunkts bei vereinfachender Annahme, dass es sich um eine etwa kreisförmige Anordnung handelt r = 0,0375 cm. Die von einem Rasterpunkt 15 bedeckte Fläche F beträgt dann F = π r² = 0,00441 cm². Bei acht Rasterpunkten pro cm² ergibt sich dann eine beschichtete Fläche von etwa 0,035 cm², was einem Bedeckungsgrad von etwa 3,5 % bezogen auf die Gesamtfläche entspricht. Somit beträgt das Verhältnis der beschichteten zu den unbeschichteten Bereichen der Oberfläche des Trägers 10 hier etwa 0,036.

Die beiden Beispiele sowie weitere Versuche des Anmelders zeigen, dass etwa Bedeckungsgrade (Verhältnis beschichtete Fläche zur Gesamtfläche, die das Beschichtungsraster aufweist) im Bereich von weniger als etwa 5 % bis etwa 30 %, insbesondere etwa 10 % bis etwa 30 % im besonders vorteilhaften Bereich liegen, wobei einerseits eine ausreichende Lichtabgabe der beschichteten Bereiche gegeben ist, andererseits aber auch noch eine ausreichende Durchsicht durch den bevorzugt transparenten Träger möglich ist, da die nicht beschichteten Zwischenräume 17 eine ausreichende Fläche ausmachen.

Das Verhältnis der beschichteten Bereiche der Fläche zu den neutralen unbeschichteten Bereichen der Fläche kann wie in den Beispielen gezeigt besonders bevorzugt weniger als 0,3, aber auch weniger als 0,1 betragen. Dies ist natürlich unter anderem auch abhängig von der Lichtintensität der das Licht abgebenden OLED-Rasterpunkte sowie der Beschaffenheit des Substrats sowie dem jeweils gewünschten Anwendungszweck. Es ist zu betonen, dass eine Rasterpunktdichte wie in den gezeigten Beispielen durchaus ausreichend ist für die Verwendung einer solchen Anordnung im Displaybereich, allerdings weniger für die üblichen Fernseh- oder Computerbildschirme, aber zum Beispiel für Displays im Werbe- und Informationsbereich, insbesondere für großflächige Displays dieser Art, da dort die Betrachtung oft aus größerer Entfernung erfolgt, so dass diese Bildpunktdichte für die Wiedergabe ausreichend ist.

### Bezugszeichenliste

- 10: Träger
- 11: Anodenschicht
- 12: Licht emittierende Schicht
- 13: Kathodenschicht
- 14: Abdeckschicht
- 15: Rasterpunkt
- 16: Ausschnitt aus dem Raster
- 17: Zwischenräume

## Patentansprüche

1. Plattenförmige flächig Licht abstrahlende Anordnung umfassend wenigstens eine als OLED ausgebildete Schicht/Schichtanordnung oder elektrolumineszierende Schicht/Schichtanordnung auf einem als Träger (10) dienenden Substrat, wobei die wenigstens eine als OLED ausgebildete Schicht/Schichtanordnung oder elektrolumineszierende Schicht/Schichtanordnung auf dem als Träger (10) dienenden Substrat in einem Beschichtungsraster aufgebracht ist, **dadurch gekennzeichnet, dass** die wenigstens eine als OLED ausgebildete Schicht/ Schichtanordnung oder elektrolumineszierende Schicht/Schichtanordnung voneinander getrennte beabstandete Licht abgebende beschichtete Bereiche aufweist und die Flächendichtedieser Licht abgebenden beschichteten Bereiche (Lichtpunkte/Bildpunkte) derart gering gewählt ist, dass das Verhältnis der Licht abgebenden beschichteten Bereiche der Fläche der plattenförmigen Anordnung zu den neutralen unbeschichteten Bereichen der Fläche der plattenförmigen Anordnung weniger als 0,3 beträgt und weniger als 20 Licht abgebende beschichtete Bereiche pro cm² der Fläche der plattenförmigen Anordnung vorgesehen sind, und die plattenförmige Anordnung erste Teilflächen mit einem transparenten Träger aus einem transparenten Trägermaterial als Träger (10) dienendes Substrat umfasst, wobei die Licht abgebende beschichteten Bereiche auf dem transparenten Trägermaterial aufgebracht sind und die neutralen unbeschichteten Bereiche des transparenten Trägermaterials, d.h. die Zwischenräume (17) des Beschichtungsrasters transparent sind, sowie weitere Teilflächen mit einem anderen nicht transparenten Träger aus einem anderen nicht transparenten Trägermaterial als Träger (10) dienendes Substrat umfasst und beide Teilflächen der plattenförmigen Anordnung mit einem jeweils gleichen, ähnlichen oder unterschiedlichen Beschichtungsraster aus Licht abgebenden beschichteten Bereichen versehen sind.

2. Plattenförmige flächig Licht abstrahlende Anordnung umfassend wenigstens eine als OLED ausgebildete Schicht/Schichtanordnung oder elektrolumineszierende Schicht/Schichtanordnung auf einem als Träger (10) dienenden Substrat, wobei die wenigstens eine als OLED ausgebildete Schicht/Schichtanordnung oder elektrolumineszierende Schicht/Schichtanordnung auf dem als Träger (10) dienenden Substrat in einem Beschichtungsraster aufgebracht ist, **dadurch gekennzeichnet, dass** die wenigstens eine als OLED ausgebildete Schicht/ Schichtanordnung oder elektrolumineszierende Schicht/Schichtanordnung voneinander getrennte beabstandete Licht abgebende beschichtete Bereiche aufweist und die Flächendichte dieser Licht abgebenden beschichteten Bereiche (Lichtpunkte/Bildpunkte) derart gering gewählt ist, dass das Verhältnis der Licht abgebenden beschichteten Bereiche der Fläche der plattenförmigen Anordnung zu den neutralen unbeschichteten Bereichen der Fläche der plattenförmigen Anordnung weniger als 0,3 beträgt und weniger als 20 Licht abgebende beschichtete Bereiche pro cm² der Fläche der plattenförmigen Anordnung vorgesehen sind, und die plattenförmige Anordnung auf einem transparenten Träger erste in ausgeschaltetem Zustand transparente oder weitgehend transparente Licht abgebende beschichtete Bereiche sowie weitere in ausgeschaltetem Zustand nicht transparente Licht abgebende beschichtete Bereiche umfasst, welche in ausgeschaltetem Zustand als passiver Sonnenschutz dienen, und die neutralen unbeschichteten Bereiche des transparenten Trägers, d.h. die Zwischenräume (17) des Beschichtungsrasters transparent sind.

3. Plattenförmige flächig Licht abstrahlende Anordnung nach Anspruch 1 oder 2, **dadurch gekennzeichnet, dass** das Verhältnis der Licht abgebenden beschichteten Bereiche der Fläche der plattenförmigen Anordnung zu den neutralen unbeschichteten Bereichen der Fläche der plattenförmigen Anordnung weniger als 0,25 beträgt.

4. Plattenförmige flächig Licht abstrahlende Anordnung nach einem der Ansprüche 1 bis 3, **dadurch gekennzeichnet, dass** der transparente Träger wenigstens ein mindestens teilweise transparenter plattenförmiger Träger, vorzugsweise aus Glas oder Kunststoffglas ist, welcher auf einer Seite oder auf beiden Seiten eines als OLED ausgebildete Schicht/Schichtanordnung oder elektrolumineszierende Schicht/Schichtanordnung aufweist.

5. Plattenförmige flächig Licht abstrahlende Anordnung nach einem der Ansprüche 1 bis 4 **dadurch gekennzeichnet, dass** das Beschichtungsraster der wenigstens einen als OLED ausgebildete Schicht/Schichtanordnung oder elektrolumineszierende Schicht/Schichtanordnung ein Punktraster oder Strichraster ist.

6. Plattenförmige flächig Licht abstrahlende Anordnung nach einem der Ansprüche 1 bis 5, **dadurch gekennzeichnet, dass** mehrere gegebenenfalls funktional unterschiedliche als OLED ausgebildete Schichten/Schichtanordnungen oder elektrolumineszierende Schichten/ Schichtanordnungen in Beschichtungsrastern mit jeweils auf dem als Träger (10) dienenden Substrat nebeneinander, übereinander oder versetzt übereinander liegenden Licht abgebenden beschichteten Bereichen aufgebracht sind.

7. Plattenförmige flächig Licht abstrahlende Anordnung nach einem der Ansprüche 1 bis 6, **dadurch gekennzeichnet, dass** für die Kontaktierung der Licht abgebenden beschichteten Bereiche durchgehende Elektrodenschichten vorgesehen sind oder für die Kontaktierung der Licht abgebenden beschichteten Bereiche den einzelnen Licht abgebenden beschichteten Bereichen zugeordnete voneinander getrennte Kontaktschichtbereiche, wobei die Zwischenräume (17) zwischen diesen gegebenenfalls isolierend ausgebildet sind, vorgesehen sind.

8. Plattenförmige flächig Licht abstrahlende Anordnung nach einem der Ansprüche 1 bis 7, **dadurch gekennzeichnet, dass** eine Steuerung vorgesehen ist, mittels derer einzelne Licht abgebende beschichtete Bereiche oder eine Gruppe von Licht abgebenden beschichteten Bereichen jeweils separat ansteuerbar sind, so dass deren Licht abgebende Funktion voneinander unabhängig ein- und ausschaltbar ist.

9. Plattenförmige flächig Licht abstrahlende Anordnung nach einem der Ansprüche 1 bis 8, **dadurch gekennzeichnet, dass** mindestens ein Teil der Licht abgebenden beschichteten Bereiche an einer Seite mit einer schwarzen, grauen, dunklen oder spiegelnden Abdeckung versehen sind.

10. Plattenförmige flächig Licht abstrahlende Anordnung nach einem der Ansprüche 1 bis 9, **dadurch gekennzeichnet, dass** die Größe der Licht abgebenden beschichteten Bereiche und/oder die Abstände zwischen diesen innerhalb eines Beschichtungsrasters variiert.

## Claims

1. Board-shaped planar light emitting assembly, comprising at least one OLED layer/layer arrangement or electroluminescent layer/layer arrangement on a substrate serving as a carrier (10), wherein the at least one OLED layer/layer arrangement or electroluminescent layer/layer arrangement is applied to the substrate serving as a carrier (10) in a coating matrix,
**characterized in that**
the at least one OLED layer/layer arrangement or electroluminescent layer/layer arrangement comprises separate light-emitting coated areas spaced apart from each other and the surface density of these light-emitting coated areas (light points/pixels) is selected to be low enough that the ratio of the light-emitting coated areas of the surface of the board-shaped assembly to the neutral uncoated areas of the surface of the board-shaped assembly is less than 0.3 and fewer than 20 light-emitting coated areas per cm² of the surface of the board-shaped assembly are provided, and the board-shaped assembly comprises first sub-surfaces with a transparent carrier made from transparent carrier material as a substrate serving as a carrier (10), wherein the light-emitting coated areas are applied to the transparent carrier material and the neutral uncoated areas of the transparent carrier material, i.e. the intermediate spaces (17) of the coating matrix, are transparent, and also comprises additional sub-surfaces with another non-transparent carrier made from another non-transparent carrier material as the substrate serving as a carrier (10), and both sub-surfaces of the board-shaped assembly are each provided with an identical, similar or different coating matrix made from light-emitting coated areas.

2. Board-shaped planar light emitting assembly, comprising at least one OLED layer/layer arrangement or electroluminescent layer/layer arrangement on a substrate serving as a carrier (10), wherein the at least one OLED layer/layer arrangement or electroluminescent layer/layer arrangement is applied to the substrate serving as a carrier (10) in a coating matrix,
**characterized in that**
the at least one OLED layer/layer arrangement or electroluminescent layer/layer arrangement comprises separate light-emitting coated areas spaced apart from each other and the surface density of these light-emitting coated areas (light points/pixels) is selected to be low enough that the ratio of the light-emitting coated areas of the surface of the board-shaped assembly to the neutral uncoated areas of the surface of the board-shaped assembly is less than 0.3 and fewer than 20 light-emitting coated areas per cm² of the surface of the board-shaped assembly are provided, and the board-shaped assembly comprises first light emitting coated areas on a transparent carrier that are transparent or largely transparent in the switched off condition and further light emitting coated areas that are non-transparent in the switched off condition, which act as passive solar protection in the switched off condition, and the neutral uncoated areas of the transparent carrier material, i.e. the intermediate spaces (17) of the coating matrix, are transparent.

3. Plate-shaped planar light emitting assembly according to Claim 1 or 2,
**characterized in that**
the ratio of the coated areas of the surface of the board-shaped assembly to the neutral uncoated areas of the surface of the board-shaped assembly is less than 0.25.

4. Plate-shaped planar light emitting assembly according to any one of Claims 1 to 3,
**characterized in that**
the transparent carrier is at least one at least partially transparent board-shaped carrier, preferably made of glass or plastic-glass, which comprises an OLED layer/layer arrangement or electroluminescent layer/slice arrangement on one side or on both sides.

5. Plate-shaped planar light-emitting assembly according to any one of Claims 1 to 4,
**characterized in that**
the coating matrix of the at least one OLED layer/layer arrangement or electroluminescent layer/layer arrangement is a dot matrix or line raster.

6. Plate-shaped planar light emitting assembly according to any one of Claims 1 to 5,
**characterized in that**
a plurality of possibly functionally different OLED layers/layer arrangements or electroluminescent layers/layer arrangements are applied in coating matrices with light-emitting coated areas each located on the substrate serving as the carrier (10) either next to each other or on top of each other, directly or offset.

7. Plate-shaped planar light emitting assembly according to any one of Claims 1 to 6,
**characterized in that**
for contacting the light-emitting coated areas continuous electrode layers are provided, or for contacting the light-emitting coated areas contact layer areas separated from each other and assigned to the individual light-emitting coated areas are provided, wherein the intermediate spaces between said contact layer areas are designed to be insulating if required.

8. Plate-shaped planar light emitting assembly according to any one of Claims 1 to 7,
**characterized in that**
a control unit is provided, by means of which individual light-emitting coated areas or a group of light-emitting coated areas can each be separately controlled so that their light-emitting function can be switched on and off independently of each other.

9. Plate-shaped planar light emitting assembly according to any one of Claims 1 to 8,
**characterized in that**
at least a part of the light-emitting coated areas are provided on one side with a black, grey, dark or reflective covering.

10. Plate-shaped planar light emitting assembly according to any one of Claims 1 to 9,
**characterized in that**
the size of the light-emitting coated areas and/or the distances between them varies within a coating matrix.

## Revendications

1. Agencement en forme de plaques émettant de la lumière en nappe comprenant au moins une couche/un agencement de couches constitué comme une DELO (diode électroluminescente organique) ou une couche/un agencement de couches électroluminescent sur un substrat servant de support (10), au moins une couche/un agencement de couches constitué comme une DELO ou une couche/un agencement de couches électroluminescent étant appliqué sur le substrat servant de support (10) dans une trame de revêtement **caractérisé en ce qu'**au moins une couche/un agencement de couches constitué comme une DELO ou une couche/un agencement de couches électroluminescent comporte des zones revêtues séparées distantes les unes des autres émettant de la lumière et la densité superficielle de ces zones revêtues émettant de la lumière (points lumineux/pixels) est choisie faible de telle manière que le rapport entre les zones émettant de la lumière de la surface de l'agencement en forme de plaques et les zones neutres non revêtues de la surface de l'agencement en forme de plaques est inférieur à 0,3 et moins de 20 zones revêtues émettant de la lumière sont prévues par cm² de la surface de l'agencement en forme de plaques et l'agencement en forme de plaques comprend des premières parties de surface avec un support transparent composé d'un substrat de matériau de support transparent servant de support (10), les zones revêtues émettant de la lumière étant appliquées sur le matériau de support transparent non revêtu et les zones neutres du matériau de support transparent, c'est-à-dire les espaces intermédiaires (17) de la trame de revêtement, étant transparentes, et comprend aussi bien d'autres parties de surface avec un autre support non transparent composé d'un substrat d'un autre matériau de support non transparent servant de support (10) et les deux parties de surface de l'agencement en forme de plaques étant dotées de trames de revêtement respectivement égales, analogues ou différentes composées de zones revêtues émettant de la lumière.

2. Agencement en forme de plaques émettant de la lumière en nappe comprenant au moins une couche/un agencement de couches constitué comme une DELO (diode électroluminescente organique) ou une couche/un agencement de couches électroluminescent sur un substrat servant de support (10), au moins une couche/un agencement de couches constitué comme une DELO ou une couche/un agencement de couches électroluminescent étant appliqué sur le substrat servant de support (10) dans une trame de revêtement, **caractérisé en ce qu'**au moins une couche/un agencement de couches constitué comme une DELO ou une couche/un agencement de couches électroluminescent comporte des zones revêtues séparées distantes les unes des autres émettant de la lumière et la densité superficielle de ces zones revêtues émettant de la lumière (points lumineux/pixels) est choisie faible de telle manière que le rapport entre les zones émettant de la lumière de la surface de l'agencement en forme de plaques et les zones neutres non revêtues de la surface de l'agencement en forme de plaques est inférieur à 0,3 et moins de 20 zones revêtues émettant de la lumière sont prévues par cm² de la surface de l'agencement en forme de plaques et l'agencement en forme de plaques comprend sur un support transparent des premières zones revêtues émettant de la lumière transparentes ou largement transparentes à l'état déconnecté, aussi bien que d'autres zones revêtues émettant de la lumière non transparentes à l'état déconnecté, lesquelles à l'état déconnecté servent de protection solaire passive et les zones neutres non revêtues du support transparent, c'est-à-dire les espaces intermédiaires (17) de la trame de revêtement, sont transparentes.

3. Agencement en forme de plaques émettant de la lumière en nappe selon la revendication 1 ou 2, **caractérisé en ce que** le rapport entre les zones revêtues émettant de la lumière de la surface de l'agencement en forme de plaques et les zones neutres non revêtues de la surface de l'agencement en forme de plaques est inférieur à 0,25.

4. Agencement en forme de plaques émettant de la lumière en nappe selon l'une quelconque des revendications 1 à 3, **caractérisé en ce que** le support transparent est au moins un support partiellement transparent en forme de plaques, de préférence en verre ou verre plastique, lequel comporte sur un côté ou sur les deux côtés une couche/un agencement de couches constitué comme une DELO ou une couche/un agencement de couches électroluminescent.

5. Agencement en forme de plaques émettant de la lumière en nappe selon l'une quelconque des revendications 1 à 4, **caractérisé en ce que** la trame de revêtement d'au moins une couche/un agencement de couches constitué comme une DELO ou une couche/un agencement de couches électroluminescent est une trame à points ou une trame à traits.

6. Agencement en forme de plaques émettant de la lumière en nappe selon l'une quelconque des revendications 1 à 5, **caractérisé en ce que** plusieurs couches/agencements de couches constitués comme une DELO ou couches/agencements de couches électroluminescents, le cas échéant fonctionnellement différents, sont appliqués dans des trames de revêtement avec respectivement des zones revêtues émettant de la lumière les unes à côtés des autres, les unes sur les autres ou superposées décalées, sur le substrat servant de support (10).

7. Agencement en forme de plaques émettant de la lumière en nappe selon l'une quelconque des revendications 1 à 6, **caractérisé en ce que** pour la mise en contact des zones revêtues émettant de la lumière des couches d'électrodes continues sont prévues ou pour la mise en contact des zones revêtues émettant de la lumière des zones de couche de contact séparées les unes des autres attribuées aux zones individuelles revêtues émettant de la lumière sont prévues, les espaces intermédiaires (17) étant constitués le cas échéant entre celles-ci de façon isolante.

8. Agencement en forme de plaques émettant de la lumière en nappe selon l'une quelconque des revendications 1 à 7, **caractérisé en ce qu'**une commande est prévue au moyen de laquelle des zones individuelles revêtues émettant de la lumière ou un groupe de zones revêtues émettant de la lumière peuvent être respectivement séparément activés de manière que leur fonction d'émission de lumière peut être mise en marche ou arrêtée indépendamment l'unes de l'autre.

9. Agencement en forme de plaques émettant de la lumière en nappe selon l'une quelconque des revendications 1 à 8, **caractérisé en ce que** les zones revêtues émettant de la lumière, au moins pour une partie, sont dotées sur un côté d'une couverture noire, grise, sombre ou réfléchissante.

10. Agencement en forme de plaques émettant de la lumière en nappe selon l'une quelconque des revendications 1 à 9, **caractérisé en ce que** la grandeur des zones revêtues émettant de la lumière et/ou les distances entre celles-ci varient à l'intérieur d'une trame de revêtement.
